Europäisches Patentamt

European Patent Office

Office européen des brevets

(19)

(11) Veröffentlichungsnummer: **0 066 801**
B1

# (12) EUROPÄISCHE PATENTSCHRIFT

(45) Veröffentlichungstag der Patentschrift:
23.01.85

(21) Anmeldenummer: 82104670.3

(22) Anmeldetag: 27.05.82

(51) Int. Cl.⁴: **H 02 M 1/00**, H 01 L 25/00, H 02 M 7/19

(54) Thyristoranordnung mit mindestens vier Thyristorsäulen.

(30) Priorität: 10.06.81 DE 3123019

(43) Veröffentlichungstag der Anmeldung:
15.12.82 Patentblatt 82/50

(45) Bekanntmachung des Hinweises auf die Patenterteilung:
23.01.85 Patentblatt 85/4

(84) Benannte Vertragsstaaten:
DE GB SE

(56) Entgegenhaltungen:
FR - A - 2 311 443
US - A - 3 633 046

(73) Patentinhaber: Siemens Aktiengesellschaft, Berlin und München Wittelsbacherplatz 2, D-8000 München 2 (DE)

(72) Erfinder: Vukasovic, Lovro, Dipl.-Ing., Dresdener Strasse 8c, D-8520 Erlangen (DE)

EP 0 066 801 B1

## Beschreibung

Die Erfindung betrifft eine Thyristoranordnung mit mindestens vier Thyristorsäulen, die jeweils eine Serienschaltung von n in Verbindungspunkten miteinander verbundenen Thyristoren aufweisen, wobei wenigstens alle p-ten Verbindungspunkte der Thyristoren unterschiedlicher Thyristorsäulen über Querverbindungen untereinander verbunden sind und wobei die Thyristoren in jeweils gleicher Anzahl einer ersten und einer zweiten Leitrichtung der Thyristoranordnung zugeordnet sind.

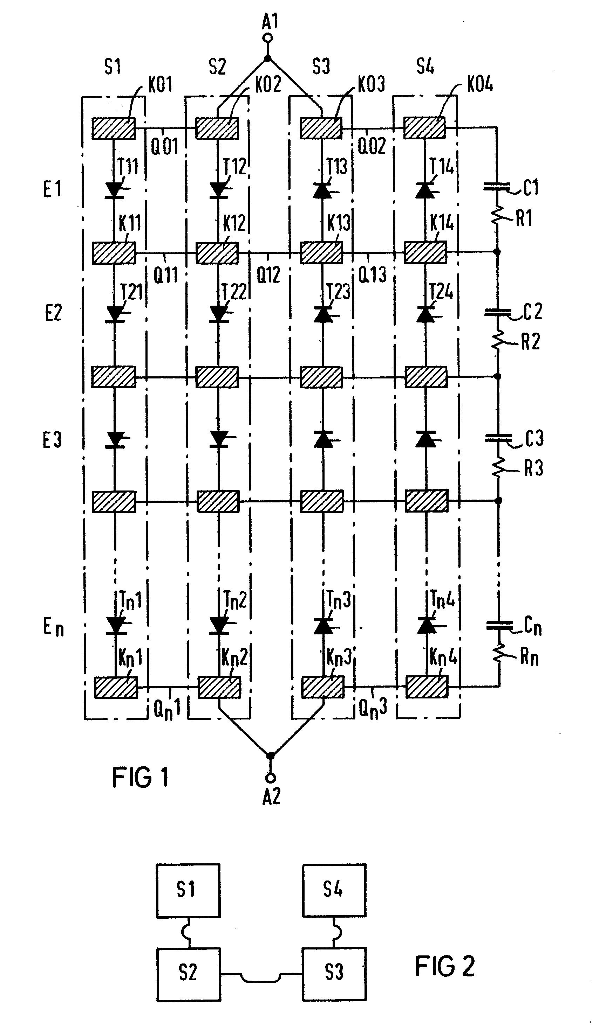

Thyristorsäulen dieser Art sind beispielsweise aus der DE-OS 2 348 206 bekannt. Dabei sind Scheibenthyristoren aufeinander gestapelt und federnd gehalten, wobei jeweils zwischen zwei Scheibenthyristoren ein Kühlkörper eingefügt ist, der gleichzeitig zur elektrischen Stromführung dient. Bei höheren Strombelastungen können mehrere derartige Säulen parallel geschaltet und bei Thyristoranordnungen mit zwei Leitrichtungen können derartige Thyristorsäulen antiparallel geschaltet werden. Eine Thyristoranordnung mit jeweils zwei parallel geschalteten Thyristorsäulen für jede Leitrichtung weist daher insgesamt vier Thyristorsäulen auf. Zur gleichmäßigen Stromaufteilung auf die vier Thyristorsäulen werden bei handelsüblichen Geräten alle zugeordneten Thyristoren der vier Thyristorsäulen miteinander verbunden. Eine derartige Anordnung ist in Fig. 1 dargestellt. Dabei sind mit S1 bis S4 die vier Thyristorsäulen bezeichnet, die gemeinsame Anschlüsse A1, A2 aufweisen. Jede Thyristorsäule besteht aus n Thyristoren T11 bis Tn1 bzw. T12 bis Tn2 usw. Die den Thyristoren zugeordneten Kühlkörper K01 bis Kn4 sind in Fig. 1 nur schematisch angedeutet. Die Thyristorsäulen S1 und S2 sind parallel geschaltet. Antiparallel zu den Thyristorsäulen S1 und S2 liegt die Parallelschaltung der Thyristorsäulen S3 und S4. Die sich entsprechenden Kühlkörper K11 bis K14, K21 bis K24 ... Kn1 bis Kn4 sind über Querverbindungen Q11 bis Qn3 miteinander verbunden. Allgemein gesagt sind also alle Kühlkörper Kp1 bis Kp4 miteinander verbunden, wobei p von 1 bis n läuft. Durch diese Verbindung der Kühlkörper sind also auch alle zugeordneten Thyristoren T11 bis T14, T21 bis T24 ... Tn1 bis Tn4 miteinander verbunden. Alle einander zugeordneten Thyristoren Tp1 bis Tp4 mit den Kühlkörpern Kp1 bis Kp4 der vier Thyristorsäulen S1 bis S4 werden im folgenden als Etage Ep der Thyristoranordnung bezeichnet. Die Thyristoranordnung weist also n Etagen E1 bis En auf.

Jeder Etage E1 bis En der Thyristoranordnung ist ein gemeinsames RC-Glied R1, C1 bis Rn, Cn zugeordnet, das zwischen den Kühlkörpern zweier benachbarter Etagen liegt.

Die räumliche Anordnung der vier Thyristorsäulen S1 bis S4 ist in Fig. 2 schematisch dargestellt. Die vier Thyristorsäulen S1 bis S4 sind in rechteckiger Form angeordnet und die Querverbindungen sind als Strombänder ausgeführt. Dabei ist konstruktionsbedingt der Abstand zwischen den Säulenpaaren S1, S2 und S3, S4 untereinander größer als der Abstand zwischen den Säulen S1 und S2 bzw. S3 und S4, so daß die Querverbindungen Q12 bis Qn2 länger sind als die übrigen Querverbindungen.

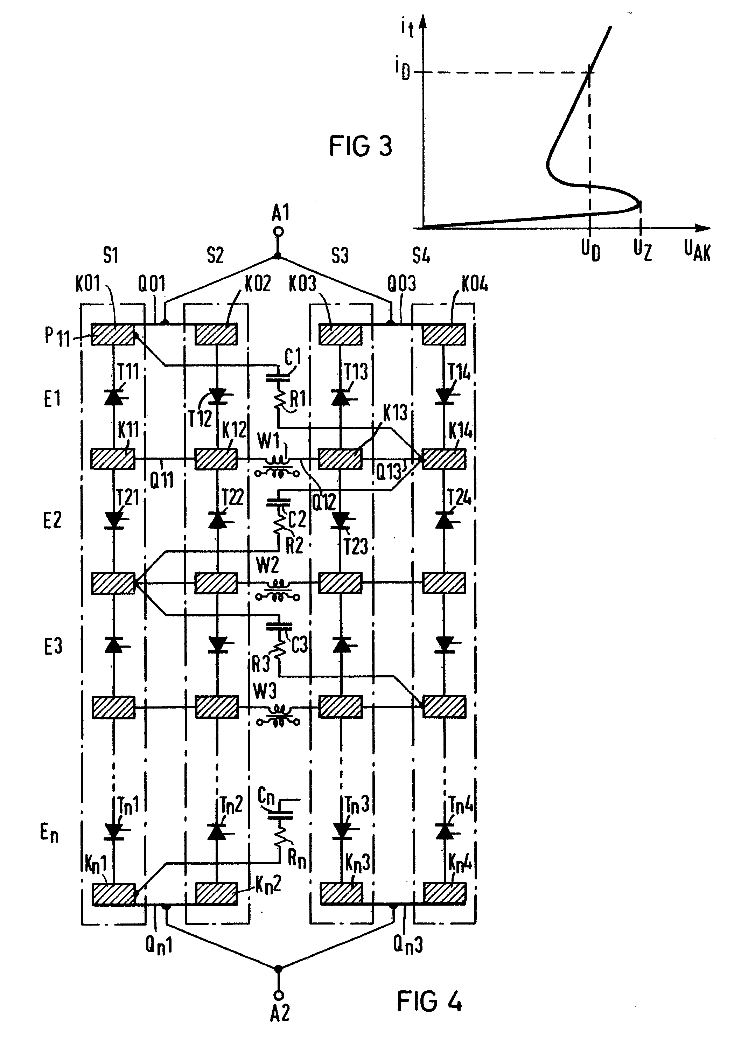

Nachteilig ist bei dieser Thyristoranordnung, daß die einzelnen Thyristoren der vier Thyristorsäulen S1 bis S4 aufeinander abgestimmt werden müssen, d. h. entsprechend ihrer dynamischen Durchlaßkennlinie sortiert werden müssen. Eine typische dynamische Durchlaßkennlinie für Hochleistungsthyristoren ist in Fig. 3 dargestellt. Diese Figur zeigt den Verlauf des Thyristorstroms $i_t$ in Abhängigkeit von der Anoden-Kathoden-Spannung des Thyristors. Dabei ist die Zündspannung mit $U_z$ und die Durchlaßspannung beim Thyristorstrom $i_D$ mit $U_D$ bezeichnet. Bei einer derartigen Kennlinie der Thyristoren kann es bei Streuung der Zündzeitpunkte vorkommen, daß die Durchlaßspannung eines von mehreren parallel geschalteten Thyristoren zuerst zündenden Thyristors kleiner ist als die Zündspannung der anderen Thyristoren. In diesem Fall würden die restlichen Thyristoren nicht mehr zünden und der zuerst zündende Thyristor den vollen Strom übernehmen und damit überlastet werden. Um die Zündung alle Thyristoren sicherzustellen, müssen diese nach ihren Zündspannungen $U_z$ sortiert werden. Weiterhin ist aber auch eine Sortierung nach der Durchlaßspannung $U_D$ erforderlich, da bei unterschiedlichen Durchlaßspannungen parallel geschalteter Thyristoren diese sich im statischen Zustand ungleichmäßig an der Stromführung beteiligen. Diese Sortierung nach zwei Kriterien bereitet in der Praxis größere Schwierigkeiten. Außerdem kann es z. B. durch Alterung oder Unterschieden in der Zündverzögerungszeit trotz dieser Sortierung vorkommen, daß nur ein Thyristor zündet und die parallel geschalteten Thyristoren unter ihrer Zündspannung bleiben. Um diesen Fall mit Sicherheit auszuschließen, dürfte man für Parallelschaltungen nur Thyristoren verwenden, deren Zündspannung unter der Durchlaßspannung liegt. Diese Auswahl ist jedoch sehr aufwendig.

Bei der bekannten Thyristoranordnung ist außerdem problematisch, daß trotz der Querverbindungen zwischen den Thyristorsäulen sich eine durch abweichende Eigenschaften eines Thyristors entstandene ungleichmäßige Stromverteilung über die ganze Säule fortsetzt. Während nämlich die Verbindung der Thyristoren über die Kühlkörper wegen der geringen Länge der Verbindung äußerst induktivitätsarm ist, weisen die längeren Querbindungen eine höhere Induktivität auf, so daß ein Ausgleich über die Querverbindungen zumindest nicht in kurzer Zeit stattfindet und die Stromaufteilung immer schlechter wird.

Um die Stromverteilung von parallel geschalteten Thyristoren zu verbessern, ist es aus dem BBC-Silicium-Stromrichter-Handbuch 1971, Seiten 95, 96 bekannt, jedem einzelnen Thyristor einer Parallelschaltung eine Luftdrossel in Serie zu schalten. Durch die Wirkung der Luftdrossel wird der zuerst zündende Thyristor nicht sofort den vollen Strom übernehmen, und die Spannung an den übrigen Thyristoren steigt durch die Stromänderung in der Drossel an, so daß deren Zündung unterstützt wird. Diese Drosseln für jeden einzelnen Thyristor sind jedoch verhältnismäßig aufwendig und würden bei Anwendung in einer Thyristorsäule deren Baulänge erheblich vergrößern, da sie zusätzlich zwischen Thyristor und Kühlkörper eingefügt werden müßten.

Aufgabe der Erfindung ist es daher, eine Thyristoranordnung der eingangs genannten Art so auszugestalten, daß eine Vergleichmäßigung der Zündung und der Stromaufteilung von parallel geschalteten Thyristoren auch ohne gesonderte Drosseln erreicht wird.

Diese Aufgabe wird erfindungsgemäß dadurch gelöst, daß in jeder Thyristorsäule nach jedem eine Querverbindung aufweisenden p-ten Verbindungspunkt die Leitrichtung der Thyristoren innerhalb der Thyristorsäule wechselt, so daß bei jeder Stromrichtung der Stromfluß zwischen den Thyristorsäulen wechselt.

Der Strom kann also nicht durch eine einzelne Thyristorsäule fließen, sondern der Stromfluß wechselt von Thyristorsäule zu Thyristorsäule. Es wird damit über die Querverbindungen geführt, die eine wesentlich höhere Induktivität aufweisen als die Verbindungen innerhalb der Thyristorsäulen. An den Querverbindungen entsteht beim Einschalten jedes Thyristors ein induktiver Spannungsabfall, der die an noch nicht gezündeten Thyristoren anstehende Spannung für eine gewisse Zeit aufrechterhält und somit deren Zündung begünstigt. Außerdem kann wegen des Wechsels des Stromflusses zwischen den Thyristorsäulen eine einmal entstandene ungleichmäßige Stromverteilung sich nicht über eine ganze Thyristorsäule fortsetzen. Wie bei den Schaltungen mit gesonderten Stromverteilerdrosseln wird auch die statische Stromaufteilung verbessert. Diese Vorteile werden ohne Veränderung des konstruktiven Aufbaus der Thyristorsäulen und ohne jeglichen Mehraufwand erzielt. Die Querverbindungen müssen für den vollen Thyristorstrom ausgelegt werden, was jedoch auch schon bei den bekannten Anordnungen der Fall war, da die Querverbindungen dort bei Ausfall eines Thyristors ebenfalls den vollen Strom übernehmen.

Vorteilhafterweise ist in jeder Thyristorsäule zwischen je zwei Thyristoren je ein Kühlkörper angeordnet, der die beiden Thyristoren verbindet, wobei die Querverbindungen als Verbindungsleitungen zwischen entsprechenden Kühlkörpern ausgeführt werden. Eine derartige Verbindung zwischen den Thyristoren der einzelnen Thyristorsäulen ist besonders einfach, da sie ohne gesonderte Anschlußelemente durchgeführt werden kann.

Zweckmäßigerweise wird die Leitungslänge der Querverbindungen so gewählt, daß der induktive Spannungsabfall an den Querverbindungen beim Einschalten der Thyristoranordnung größer ist als die größte Differenz von Durchlaßspannungen und Zündspannungen der mit den Querverbindungen verbundenen Thyristoren der verschiedenen Thyristorsäulen. Damit wird erreicht, daß jeder Thyristor sicher gezündet wird, auch wenn die Zündspannung über der Durchlaßspannung liegt.

Den über eine Querverbindung miteinander verbundenen Thyristoren aller Thyristorsäulen kann ein gemeinsames RC-Glied parallel geschaltet sein, das zwischen dem p-ten und dem (p + 1)-ten Verbindungspunkt der Thyristoren zweier verschiedener Thyristorsäulen liegt. Durch diese Schaltung des RC-Gliedes fließt dessen Entladestrom beim Einschalten der zugehörigen Thyristoren über einen relativ langen Verbindungsweg, so daß ein verhältnismäßig hoher induktiver Spannungsabfall entsteht, der die Zündung noch nicht durchgezündeter Thyristoren weiter begünstigt. Dabei ist es vorteilhaft, wenn das RC-Glied zwischen den Anschlüssen der Thyristoren derjenigen Thyristorsäulen liegt, die die größte Leitungslänge der Querverbindungen aufweisen, da damit der höchste induktive Spannungsabfall entsteht.

In einer Querverbindung kann ein Stromfühler angeordnet sein. Dabei wird diejenige Querverbindung gewählt, die nur von Ausgleichströmen der Parallelschaltung durchflossen ist. Damit kann eine eventuelle Stromfehlverteilung gemessen werden, wobei im Gegensatz zu bekannten Anordnungen für jedes parallel geschaltete Thyristorpaar nur ein Stromfühler für beide Stromrichtungen erforderlich ist.

Ein Ausführungsbeispiel der Erfindung wird nachfolgend anhand der Fig. 4 näher erläutert.

Die dargestellte Thyristoranordnung besteht aus vier Thyristorsäulen S1 bis S4. In jeder Thyristorsäule sind Scheibenthyristoren T11 bis Tn1, T12 bis Tn2, T13 bis Tn3, T14 bis Tn4 aufeinander gestapelt, wobei jeder Thyristor zwischen zwei Kühlkörpern K01 bis Kn4 eingefügt ist. Die Kühlkörper stellen gleichzeitig die leitende Verbindung zwischen den beiden anliegenden Thyristoren einer Thyristorsäule her. Die auf gleichem Potential liegenden Thyristoren T11 bis T14, T21 bis T24 usw. sind zusammen mit den ihnen zugeordneten Kühlkörpern K11 bis K14, K21 bis K24 usw. als Etagen E1, E2 usw. bezeichnet. Zwischen den Kühlkörpern einer Etage E1 bis En aller Säulen S1 bis S4 besteht jeweils eine Querverbindung Q11 bis Qn3. Die beiden ersten Kühlkörper K01 und K02 der Thyristorsäulen S1 und S2 sind über eine Querverbindung Q01 und die beiden ersten Kühlkörper K03 und K04 der Thyristorsäulen S3 und S4 sind über eine Querverbindung Q03 verbunden. Diese beiden Querverbindungen Q01 und Q03 sind an die Anschlußklemme A1 angeschlossen. In entsprechender Weise sind auch die letzten Kühlkörper Kn1 bis Kn4 mit der Anschlußklemme A1 verbunden.

Die Polung der Thyristoren T1 bis Tn4 ist nun so gewählt, daß an jedem Kühlkörper K11 bis Kn4 entweder die Anoden oder die Kathoden der beiden anliegenden Thyristoren angeschlossen sind, d. h., daß die Polung der Thyristoren innerhalb jeder Säule S1 bis S4 von Etage zu Etage wechselt. Die ersten Thyristoren der Säulen S1 und S3 sind in positiver und die ersten Thyristoren der Säulen S2 und S4 sind in negativer Leitrichtung gepolt. Damit verbindet jede Querverbindung Q11 bis Qn3 jeweils einen Kühlkörper mit Anodenanschluß und einen Kühlkörper mit Kathodenanschluß. Es ist also kein Stromfluß innerhalb einer einzelnen Thyristorsäule S1 bis S4 möglich. Ferner wechselt auch die Polung jedes Thyristors T11 bis T14 innerhalb jeder Etage E1 bis En von Thyristorsäule S1 bis Thyristorsäule S4. Bei dieser Thyristoranordnung ist ein Stromfluß nur über die Querverbindungen Q11 bis Qn4 möglich. Ein Strom von der Klemme A1 zur Klemme A2 wird beispielsweise über den Kühlkörper K02, den Thyristor T12, den Kühlkörper K12, die Querverbindung Q11, den Kühlkörper K11, den Thyristor T21 usw. sowie parallel dazu über den Kühlkörper K04, den Thyristor T14, den Kühlkörper K14, die Querverbindung Q13, den Kühlkörper K13, den Thyristor T23 usw. fließen. Ein Strom in umgekehrter Richtung fließt über die Thyristoren T22, die Querverbindung Q11 und den Thyristor T11 sowie parallel dazu über den Thyristor T24, die Querverbindung Q13 und den Thyristor T13.

Wenn bei dieser Thyristoranordnung beispielsweise der Strompfad über die Thyristoren T12 und T21 zuerst gezündet sein sollte, so entsteht an den Verbindungsleitungen, und zwar im wesentlichen an den Querverbindungen Q01 und Q11 ein induktiver Spannungsabfall, der sich zur Durchlaßspannung der Thyristoren T12 und T21 addiert. Damit steht an den zunächst noch nicht gezündeten, parallel geschalteten Thyristoren T14 und T23 eine höhere Spannung als die Durchlaßspannung der Thyristoren T12 und T21 an, so daß die Zündung der Thyristoren T14 und T23 unterstützt wird. Eine Zündung aller parallel geschalteten Thyristoren wird auch für Thyristoren, deren Durchlaßspannung unter der Zündspannung liegt, sichergestellt, wenn der induktive Spannungsabfall an den Querverbindungen die Differenz zwischen der Durchlaßspannung des zuerst gezündeten Thyristors und der gegebenenfalls höheren Zündspannung der noch nicht gezündeten Thyristoren ausgleicht, wenn also der induktive Spannungsabfall an den Querverbindungen beim Einschalten der Thyristoranordnung größer ist als die größte Differenz von Durchlaßspannungen und Zündspannungen der Thyristoren einer Etage.

Durch die Induktivität der Verbindungsleitungen wird auch die Stromaufteilung der Thyristoren im Durchlaßzustand verbessert. Die mit den Querverbindungen gegebenen Induktivitäten wirken einer Erhöhung des durch den betreffenden Zweig fließenden Stromes entgegen, während andererseits bei einer Stromerhöhung durch den induktiven Spannungsabfall die an den restlichen Thyristoren anstehenden Spannungen erhöht werden, so daß wiederum die Stromaufnahme für diese Thyristoren unterstützt wird. Insgesamt wirken die durch die Querverbindungen gegebenen Induktivitäten ähnlich wie die bekannten Stromteilerdrosseln in Richtung einer Vergleichmäßigung der Stromaufteilung.

Wie bereits eingangs erwähnt, ist es wegen des Stromwechsels von Thyristorsäule zu Thyristorsäule auch unmöglich, daß sich wie bei den bekannten Thyristoranordnungen eine einmal in einer Etage auftretende Störung der Stromverteilung über die gesamte Thyristorsäule fortsetzt.

Wie ein Vergleich von Fig. 1 mit Fig. 4 zeigt, werden diese Vorteile ohne Veränderung des Säulenaufbaus lediglich durch den umgedrehten Einbau jedes zweiten Thyristors einer Thyristorsäule erreicht. Für die beschriebene Thyristoranordnung müssen daher an den bekannten Thyristorsäulen keine weiteren Veränderungen vorgenommen werden, und es ist kein zusätzlicher Aufwand erforderlich.

In der Thyristoranordnung nach Fig. 4 ist jeder Etage E1 bis En ein RC-Glied C1R1 bis CnRn zugeordnet. Dabei ist jedes RC-Glied zwischen einem Kühlkörper K11, K12 usw. der ersten Thyristorsäule S1 und einem Kühlkörper K24, K34 usw. der folgenden Etage E1, E2 ... der vierten Thyristorsäule S4 angeschlossen. Der beim Einschalten eines Thyristors der Etage fließende Entladestrom des Kondensators C fließt damit unabhängig davon, welcher Thyristor einschaltet, immer über drei Querverbindungen Q. Dieser Entladestrom mit seiner hohen Anstiegssteilheit bewirkt damit einen relativ hohen induktiven Spannungsabfall, der die Zündung noch nicht leitender Thyristoren unterstützt. Dieser Spannungsabfall ist unabhängig von der Anstiegssteilheit des Hauptstromes.

Der Stromfluß über die Querverbindungen bei der beschriebenen Thyristoranordnung ermöglicht eine einfache Erfassung einer Stromfehlverteilung des durch die Thyristoren fließenden Stroms. Alle Ausgleichsströme zwischen den parallel geschalteten Thyristoren fließen nämlich für beide Stromrichtungen über die Querverbindungen Q12 bis Q(n−1)2 zwischen den Thyristorsäulen S2 und S3. Diese Querverbindungen sind, wie eingangs erwähnt, verhältnismäßig lang, so daß die erforderlichen Stromwandler W1 bis Wn-1 problemlos unterzubringen sind. Bei der bekannten Thyristoranordnung nach Fig. 1 müssen jede Stromrichtung gesondert zwischen den Thyristorsäulen S1 und S2 bzw. zwischen den Thyristorsäulen S3 und S4 untergebracht werden, was wegen des geringen Abstandes zwischen diesen Thyristorsäulen nur mit Schwierigkeiten möglich ist.

## Patentansprüche

1. Thyristoranordnung mit mindestens vier Thyristorsäulen (S1—S4), die jeweils eine Serienschaltung von n in Verbindungspunkten miteinander verbundenen Thyristoren (T11—Tn4)

aufweisen, wobei wenigstens alle p-ten Verbindungspunkte der Thyristoren unterschiedlicher Thyristorsäulen über Querverbindungen (Q11—Qn4) untereinander verbunden sind und wobei die Thyristoren in jeweils gleicher Anzahl einer ersten und einer zweiten Leitrichtung der Thyristoranordnung zugeordnet sind, dadurch gekennzeichnet, daß in jeder Thyristorsäule (S1—S4) nach jedem eine Querverbindung (Q11—Qn4) aufweisenden p-ten Verbindungspunkt (K11—Kn4) die Leitrichtung der Thyristoren (T11—Tn4) innerhalb der Thyristorsäule (S1—S4) wechselt, so daß bei jeder Stromrichtung der Stromfluß zwischen den Thyristorsäulen (S1—S4) wechselt.

2. Thyristoranordnung nach Anspruch 1, dadurch gekennzeichnet, daß in jeder Thyristorsäule (S1—S4) zwischen je zwei Thyristoren (T11—Tn4) je ein Kühlkörper (K11—Kn4) angeordnet ist, der die beiden Thyristoren (T11—Tn4) verbindet und daß die Querverbindungen (Q11—Qn3) als Verbindungsleitungen zwischen entsprechenden Kühlkörpern (K11—Kn4) ausgeführt sind.

3. Thyristoranordnung nach Anspruch 1 oder 2, dadurch gekennzeichnet, daß die Leitungslänge der Querverbindungen (Q11—Qn3) so gewählt wird, daß der induktive Spannungsabfall an den Querverbindungen (Q11—Qn3) beim Einschalten der Thyristoranordnung größer ist als die größte Differenz von Durchlaßspannungen und Zündspannungen der mit den Querverbindungen (Q11—Qn4) verbundenen Thyristoren (T11—Tn4) der verschiedenen Thyristorsäulen S1—S4).

4. Thyristoranordnung nach einem der Ansprüche 1 bis 3, dadurch gekennzeichnet, daß den über eine Querverbindung (Q11—Qn4) miteinander verbundenen Thyristoren (T11—Tn4) aller Thyristorsäulen (S1—S4) ein gemeinsames RC-Glied (R1, C1—Rn, Cn) parallel geschaltet ist, das zwischen dem p-ten und dem (p + 1)-ten Verbindungspunkt (K11—Kn4) der Thyristoren (T11—Tn4) zweier verschiedener Thyristorsäulen (S1—S4) liegt.

5. Thyristoranordnung nach Anspruch 4, dadurch gekennzeichnet, daß das RC-Glied (R1, C1—Rn, Cn) zwischen den Anschlüssen der Thyristoren (T11—Tn4) derjenigen Thyristorsäulen (S1—S4) liegt, die die größte Leitungslänge der Querverbindungen (Q11—Qn4) aufweisen.

6. Thyristoranordnung nach einem der Ansprüche 1 bis 5, dadurch gekennzeichnet, daß in einer Querverbindung (Q12—Qn2) ein Stromfühler (W1—Wn) angeordnet ist.

## Claims

1. A thyristor arrangement having at least four Thyristor columns (S1—S4), each of which consist of a series arrangement of n thyristors (T11—Tn4) which are connected to one another at junction points, where at least all the p—th junction points of the thyristors of different thyristor columns are connected to one another via lateral junctions (Q11—Qn4) and where the thyristors are assigned in equal numbers to a first and a second direction of conductivity of the thyristor arrangement, characterised in that in each thyristor column (S1—S4) following each p—th junction point (K11—Kn4) which possesses a lateral junction (Q11—Qn4) the direction of conductivity of the thyristors (T11—Tn4) within the thyristor column (S1—S4) changes so that for each current direction there is a change in the current flow between the thyristor columns (S1—S4).

2. A thyristor arrangement as claimed in claim 1, characterised in that in each thyristor column (S1—S4) between each two thyristors (T11—Tn4) there is arranged a cooling body (K11—Kn4) which connects the two thyristors (T11—Tn4), and that the lateral junctions (Q11—Qn3) consist of connecting links between corresponding cooling bodies (K11—Kn4).

3. A thyristor arrangement as claimed in claim 1 or 2, characterised in that the line length of the lateral junctions (Q11—Qn3) is selected to be such that the inductive voltage drop across the lateral junctions (Q11—Qn3) when the thyristor arrangement is switched on is greater than the greatest difference between the forward voltages and ignition voltages of the thyristors (T11—Tn4) connected to the lateral junctions (Q11—Qn4) of the various thyristor columns (S1—S4).

4. A thyristor arrangement as claimed in one of the claims 1 to 3, characterised in that those thyristors (T11—Tn4) of all the thyristor columns (S1—S4) connected to one another via a lateral junction (Q11—Qn4) are connected in parallel with a common RC-element (R1, C1—Rn, Cn) arranged between the p—th and the (p + 1) —th junction point (K11—Kn4) of the thyristors (T11—Tn4) of two different thyristor columns (S1—S4).

5. A thyristor arrangement as claimed in claim 4, characterised in that the RC-element (R1, C1—Rn, Cn) is arranged between the terminals of the thyristors (T11—Tn4) of those thyristor columns (S1—S4) which possess the lateral junctions (Q11—Qn4) of longest line length.

6. A thyristor arrangement as claimed in one of the claims 1 to 5, characterised in that a current sensor (W1—Wn) is arranged in a lateral junction (Q12—Qn2).

## Revendications

1. Dispositif à thyristors comportant au moins quatre collonnes de thyristors (S1—S4), qui comportent chacune un montage série de n thyristors (T11—Tn4) reliés entre eux au niveau de points de jonction, et dans lequel au moins tous les p-èmes points de jonction des thyristors de colonnes de thyristors différentes sont reliés entre eux par l'intermédiaire de liaisons transversales (Q11—Qn4) et dans lequel les thyristors sont associés, en des nombres identiques, à un premier sens de conduction et à un second sens de conduction de dispositif à thyristors, caractérisé en ce que dans chaque colonne de thyristors (S1—S4), le sens de conduction des thyristors (T11—Tn4) à l'intérieur desdites colonnes de thyristors change après chaque p-ème point de jonction (K11—Kn4) comportant une liaison transversale (Q11—Qn4), de sorte que dans chaque sens du courant, le flux de courant alterne entre les colonnes des thyristors (S1—S4).

2. Dispositif à thyristors suivant la revendication 1, caractérisé par le fait que dans chaque colonne de thyristors (S1—S4), entre deux thyristors (T11—Tn4), se trouve disposé en corps de refroidissement (K11—Kn4) qui relie les deux thyristors (T1—T11—Tn4), et que les liaisons transversales (Q11—Qn3) sont réalisées sous la forme de conducteurs de liaison entre des corps de refroidissement (K11—Kn4) correspondants.

3. Dispositif à thyristors suivant la revendication 2, caractérisé par le fait que la longueur des liaisons tranversales (Q11—Qn3) est choisie de telle sorte que la chute de tension inductive dans ces liaisons lors du branchement du dispositif à thyristors est supérieure à la différence maximale entre la tension directe et les tensions d'amorçage des thyristors (T11—Tn4), reliés aux liaisons transversales (Q11—Qn4), des différentes colonnes de thyristors (S1—S4).

4. Dispositif à thyristors suivant l'une des revendications 1 à 3, caractérisé par le fait qu'en parallèle avec les thyristors (T11—Tn4), reliés entre eux par l'intermédiaire d'une liaison transversale (Q11—Qn4), de toutes les colonnes de thyristors (S1—S4) se trouve branché un circuit RC commun (R1, C1, Rn, Cn), qui est situé entre le p-ème et le (p + 1)-ème point de jonction (K11—Kn4) des thyristors (T11—Tn4) de deux colonnes différentes de thyristors (S1—S4).

5. Dispositif à thyristors selon la revendication 4, caractérisé en ce que le circuit RC (R1, C1—Rn, Cn) est situé entre les bornes des thyristors (T11—Tn4) des colonnes de thyristors (S1—S4) pour lesquelles la longueur des liaisons transversales (Q11—Qn4) est maximale.

6. Dispositif à thyristors selon l'une des revendications 1 à 5, caractérisé en ce qu'un détecteur de courant (W—Wn) est disposé dans une liaison transversale (Q2—Qn2).

FIG 1

FIG 2

FIG 3

FIG 4